# EUROPÄISCHE PATENTSCHRIFT

(11) **EP 3 761 503 B1**
(45) Veröffentlichungstag und Bekanntmachung des Hinweises auf die Patenterteilung: **19.10.2022**
(21) Anmeldenummer: 20182423.2
(22) Anmeldetag: 26.06.2020
(51) Int. Cl.: H01L 31/02, H02S 20/26, H02S 20/30

(54) **BAUELEMENTE MIT PHOTOVOLTAIK**
MODULES WITH PHOTOVOLTAIC SYSTEM
COMPOSANTS POURVU DE PHOTOVOLTAÏQUE

(30) Priorität: 01.07.2019 DE 102019117665
(43) Veröffentlichungstag der Anmeldung: 06.01.2021
(73) Patentinhaber: Kassner, Sabine, 10717 Berlin (DE)
(72) Erfinder: Kassner, Sabine, 10717 Berlin (DE)
(74) Vertreter: Hertin und Partner Rechts- und Patentanwälte PartG mbB

(56) Entgegenhaltungen:
- EP-A1- 3 021 056
- WO-A1-2018/130726
- CN-A- 108 540 056
- DE-A1-102011 111 803
- DE-U1- 20 106 564
- DE-U1- 29 809 868
- DE-U1-202010 000 520
- US-A1- 2010 126 087
- US-A1- 2018 262 156

## Beschreibung

Die Erfindung betrifft in einem Aspekt ein modulares Wandsystem umfassend Massivbauelemente zur modularen Errichtung selbsttragender Wandsegmente, wobei die Massivbauelemente eine oder mehrere Durchbohrungen zur Halterung von Photovoltaikmodulen aufweisen. Die Photovoltaikmodule liegen zu diesem Zweck in Kantprofilen montiert vor, welche zwei oder mehr Ausleger zur Einführung in die Durchbohrungen der Massivbauelemente aufweisen. Die Ausleger zeichnen sich dadurch aus, dass diese in Form eines Hohlprofils vorliegen und die Ableitung von stromführenden Kabeln von den Photovoltaikmodulen zu einer Innenseite des modularen Wandsystems erlauben. In einem weiteren Aspekt betrifft die Erfindung ein Gebäude umfassend eine Wand, bevorzugt eine statisch tragende Außenwand, welche von einem solchen modularen Wandsystem gebildet wird.

### Hintergrund und Stand der Technik

Die Erfindung betrifft im weitesten Sinne das Gebiet der funktionellen Nutzung von Gebäuden zur Solarenergiegewinnung.

Der Ausbau der Nutzung erneuerbarer Energiequellen zur Versorgung des Strombedarfs stellt in der heutigen Zeit eine wesentliche gesellschaftliche Herausforderung dar und wird vielerorts vorangetrieben. Im Gegensatz zu fossilen Energieträgern ist das Kontingent von erneuerbaren Energiequellen theoretisch unbegrenzt und wirkt sich positiv auf die Klimabilanz aus.

Zur Gewinnung von Solarenergie sind Photovoltaik-Freiflächenanlagen bekannt, wobei Photovoltaikmodule in einer Halterungskonstruktion ebenerdig aufgestellt werden. Eine Anpassung kann in Abhängigkeit der Halterungskonstruktion erfolgen, um sicherzustellen, dass die Module stets einen optimalen Winkel zur Sonne aufweisen. Montagesysteme für Photovoltaik-Freiflächenanlagen sind beispielsweise aus der US 2010/0038507 A1 oder US 2011/0067691 A1 bekannt.

Nachteilig an Photovoltaik-Freiflächenanlagen ist deren hoher Platzbedarf, welcher eine Nutzung im Wesentlichen auf dünnbesiedelte Gegenden begrenzt.

Im Bestreben die Solarenergiegewinnung zu steigern, ist es bekannt an Gebäuden Photovoltaikmodule insbesondere an den Dächern oder Fassaden der Gebäude anzubringen. Für die Installationen der Photovoltaikmodule sind im Stand der Technik verschiedene Lösungen bekannt.

Die JP 2013/110281 offenbart beispielsweise ein Bauelement in Form eines Rahmens zur regendichten Verkleidung einer Gebäudeaußenfläche, insbesondere eines Schrägdaches oder einer Fassade, in welche Photovoltaikmodule eingesetzt werden können.

Die US 2013/0067852 A1 und US 8,375,653 B2 offenbaren Dachelemente in Form von Schindeln oder Ziegeln mit integrierten Photovoltaikmodulen.

Aus der US 2002/0043031A1 ist ein Installationsmodul in Form einer Platte bekannt, auf welche Solarmodule aufgebracht werden können, um diese auf Dächern zu installieren.

Die DE 196 32 493 A1 schlägt ein Befestigungselement vor, welches der Anbringung von Solarmodulen auf großflächigen aus Glas bestehenden Substraten, beispielsweise einer Gebäudefassade dient. Anstelle einer Befestigung rahmenloser Solarmodule mittels Klemmen wird die Verwendung eines z-förmigen Metallprofiles zur Befestigung der Solarmodule vorgeschlagen. An einem ersten horizontalen Wandbereich des z-förmigen Metallprofiles können die Solarmodule beispielsweise mittels Kleben arretiert werden, während eine Anbringung auf dem Substrat mittels eines zweiten horizontalen Wandbereiches des Metallprofiles erfolgt. Zu diesem Zweck weist der zweite horizontale Wandbereich Durchbrechungen zur Aufnahme von Befestigungsmitteln, beispielsweise Bolzen auf.

DE 10 2008 051 717 A1 betrifft eine Punkthalterung für Verbundscheiben umfassend Solarzellen. Der Punkthalter umfasst ein Gehäuseteil zum Eingreifen in eine bevorzugt kreisförmige Glasplattenbohrung. Das Gehäuseteil weist einen Haltering mit einem Verbindungselement zur Weiterleitung des von den Solarzellen erzeugten Stromes auf und wird durch einen Bolzen gehalten. In dem Bolzen liegt eine Axialbohrung zur Führung von Anschlusskabeln vor.

Die nachträgliche Installation der Photovoltaikmodule an den Dächern oder Fassaden der Gebäude ist jedoch erfahrungsgemäß aufwendig bzw. fehlerbehaftet. In Bezug auf neu zu errichtende Gebäude wäre es daher wünschenswert, wenn eine einfache Montagemethode bestünde, um Photovoltaikmodule anzubringen bzw. in die Gebäudeerrichtung zu integrieren.

In der WO 2018/130726 A1 wird beispielsweise ein photovoltaisches Baukastensystem umfassend ein Bauelement und mindestens ein daran befestigtes Photovoltaikelement beschrieben. Das Photovoltaikelement kann dauerhaft, bspw. verklebt, mit dem Bauelement vorliegen oder aber demontierbar am Bauelement befestigt sein. Hierdurch soll eine schnelle Montage möglich sein.

Auch die WO 03/066993 A1 schlägt ein Bauelement mit integrierter Photovoltaik für verschiedene Konstruktionen vor. Hierzu wird eine Bauplatte, bei mit einer vorbereiteten Aussparung zur Aufnahme eines Photovoltaik-Elementes vorgeschlagen. Die Bauplatte besteht bevorzugt aus einem Massivbaumaterial wie u.a. Beton.

Die US 9,059,348 B1 beschreibt ein Mauerelement mit einem integrierten PhotovoltaikElement. Das Mauerelement besteht bevorzugt aus Beton, wobei das Photovoltaik-Modul über eine feste Stützstruktur positioniert und gehalten wird. Hierbei wird das Mauerelement mit einer oder mehreren Solarzellen zur Stromerzeugung beschrieben. Insbesondere wird ein photovoltaikverkleidetes Mauerelement beschrieben, das die statischen Eigenschaften eines Betonsteins (oder eines anderen Mauerelements) mit der Energieerzeugung der Photovoltaik kombiniert.

US 2012/0210658 A1 offenbart eine Plattenanordnung zur Montage an einer Fassade eines Gebäudes. Die Platten, beispielsweise aus Glas, werden bevorzugt rahmenlos installiert. Zu diesem Zweck werden in den Glasplatten zentrale Öffnungen bereitgestellt, in welche Fittings bzw. Montagerohre eingebracht werden. An den Fittings bzw. Montagerohren können ebenfalls Solarmodule fixiert werden. Die Anschlussleitungen für die Solarmodule werden über die Montagerohre bzw. Fittings von außen ins Innere der Fassade geführt.

Die DE 201 06 564 U1 offenbart ein modulares Wandsystem aus Solarbausteinen, welche in Nut-Feder-Konfiguration zu einer Wand errichtet werden können.

Die Herstellung der Bauelemente mit integrierter Photovoltaik ist technisch aufwendig und mit nicht unerheblichen Kosten verbunden. Auch schränken die Lösungen die Flexibilität in Bezug auf die verwandten Materialien und die Gebäudestruktur ein. Weiterhin ist bei diesen Lösungen zumeist die Verkabelung der Photovoltaikmodule untereinander bzw. zu einem zentralen Abnahmepunkt aufwendig. Werden die Kabel ausschließlich außenseitig geführt, kann es zudem zu witterungsbedingten Schäden beispielsweise durch Nässe oder ultravioletter Strahlung kommen.

### Aufgabe der Erfindung

Aufgabe der Erfindung war es mithin die Nachteile des Standes der Technik zu beseitigen und insbesondere eine einfache, sichere und stabile Integration von Photovoltaikmodulen in Gebäuden, zu ermöglichen.

### Zusammenfassung der Erfindung

Die Aufgabe der Erfindung wird durch die unabhängigen Ansprüche gelöst. Die abhängigen Ansprüche betreffend bevorzugte Ausführungsformen der Erfindung.

In einer bevorzugten Ausführungsform betrifft die Erfindung ein modulares Wandsystem umfassend
a) Massivbauelemente zur modularen Errichtung selbsttragender Wandsegmente und
b) Photovoltaikmodule
dadurch gekennzeichnet, dass die Massivbauelemente eine oder mehrere Durchbohrungen zur Halterung der Photovoltaikmodule aufweisen, wobei die Photovoltaikmodule in Kantprofilen montiert vorliegen, welche Ausleger zur Einführung in die Durchbohrungen der Massivbauelemente aufweisen und wobei die Ausleger in Form eines Hohlprofils vorliegen und die Ableitung mindestens eines stromführenden Kabels, bevorzugt zweier getrennt stromführender Kabel, von den Photovoltaikmodulen zu einer Innenseite des modularen Wandsystems erlauben.

Im Sinne der Erfindung bezeichnet ein modulares Wandsystem bevorzugt ein System zur Errichtung eines selbsttragenden Wandsegmentes aus mehreren Modulen, welche als Massivbauelemente bezeichnet werden. Gekennzeichnet ist das modulare Wandsystem mithin dadurch, dass selbsttragende Wandsegmente erhalten werden, anstelle beispielsweise von lediglich Verkleidungen oder Fassaden. Das modulare Wandsystem ist somit auch zur Errichtung statisch tragender Wände beispielsweise einer Gebäudehülle geeignet.

Zu diesem Zweck werden als Module für das Wandsystem Massivbauelemente verwandt. Massivbauelemente können im Gegensatz zu Leichtbauelementen als Körper mit relativ großer Masse verstanden werden, welche insbesondere geeignet sind statische Kräfte bei der Errichtung von Gebäuden aufzunehmen. Als Materialien für die Massivbauelemente können beispielsweise Mauerwerk, Beton, Holz oder Ziegel dienen.

In bevorzugten Ausführungsformen sind die Massivbauelemente monolitisch, d.h. sie können bevorzugt in einem Stück geformt werden und sind nicht auftrennbar. In besonders bevorzugten Ausführungsformen können die Massivbauelemente beispielsweise als Vollholz aus einem Baumstamm herausgefräst werden oder als ein Betonstück gegossen werden. Es kann aber auch bevorzugt sein, dass die Massivbauelemente aus wenigen massiven monolithischen Teilstücken, beispielsweise aus Ziegeln oder wenigen (zwei oder drei) Vollholzelementen, zusammengesetzt sind.

Die Massivbauelemente sind bevorzugt in Bezug auf ihre Form und Größe an die Errichtung einer Wand angepasst. Beispielsweise kann es bevorzugt sein, dass die einzelnen Massivbauelemente eine geringere Dicke, als eine Höhe oder Breite aufweisen. Die Dicke verschiedener Massivbauelemente ist bevorzugt im Wesentlichen identisch und definiert die Wandstärke des zu errichtenden Wandsystems.

Die Massivbauelemente sind bevorzugt für eine vertikale Bauweise konfiguriert, bei der ein erstes Massivbauelement auf ein zweites Massivbauelement gestapelt wird. Bevorzugt sind die gegenüberliegenden Ober- und Unterseiten der einzelnen Massivbauelemente zu diesem Zweck aufeinander abgestimmt. Beispielsweise können formschlüssige Nuten und Federn zur Ausbildung einer Steckverbindung vorgesehen sein. Die Massivbauelemente können aber auch glatte Ober- und Unterflächen aufweisen, wobei entweder deren Eigengewicht die Stabilität des Wandsegmentes gewährleistet oder aber Verbindungs- bzw. Fügemittel verwandt werden.

Mittels der Massivbauelemente ist es möglich, auf besonders einfache und flexible Weise ein gewünschtes selbsttragendes Wandsegment zu errichten. Erfindungsgemäß zeichnen sich die Massivbauelemente jedoch darüber hinaus darin aus, dass diese für eine besonders einfache Montage von Photovoltaikmodulen ausgelegt sind.

Zu diesem Zweck umfassen die Massivbauelemente eine oder mehrere Durchbohrungen zur Aufnahme von entsprechenden Auslegern einer Halterung der Photovoltaikmodule. Die Durchbohrungen liegen bevorzugt horizontal in Querrichtung vor, d.h. sie erstrecken sich bevorzugt entlang der Dicke der Massivbauelemente von einer Innen- zu einer Außenseite.

Die Form bzw. der Querschnitt der Durchbohrungen ist an die Ausleger der Halterung für die Photovoltaikmodule angepasst und kann sowohl rund, oval, eckig, kreisförmig, ellipsenförmig sein oder andere Geometrien aufweisen.

Durch Einschieben in die entsprechenden Durchbohrungen lassen sich die Photovoltaikmodule auf stabile Weise, ohne konstruktiven Mehraufwand in dem Wandsegment installieren. Vorteilhafterweise lassen sich die Photovoltaikmodule unmittelbar bei der Errichtung eines Wandsegmentes integrieren, als auch in ein bestehendes Wandsegment, welches die erfindungsgemäßen Massivbauelemente aufweist, nachrüsten.

Zum Zwecke der Montage sind die Photovoltaikmodule selbst in einem Kantprofil montiert, welches Ausleger für die Einbringung in die Durchbohrungen aufweist. Das Kantprofil weist bevorzugt eine Länge auf, welche der Länge des Photovoltaikmodules entspricht sowie Mittel zur Einfassung desselben. Es kann beispielsweise bevorzugt sein, dass das Kantprofil aus Aluminium gefertigt ist und das Photovoltaikmodul an das Kantprofil angeschweißt wird. Auch ein Verschrauben ist möglich.

Im Sinne der Erfindung hat der Begriff eines Photovoltaikmoduls bzw. Solarmoduls, die im Stand der Technik übliche Bedeutung und bezeichnet eine Vorrichtung, welche das Licht der Sonne unmittelbar in elektrische Energie umwandelt. Photovoltaikmodule bzw. Solarmodule sind vorgefertigte Einheiten aus mehreren verschalteten Solarzellen, die entsprechend der Bauweise aus Deckschicht, Verbundweise, Solarzellen, Rückschicht, beispielsweise Glas, Rahmen und elektrischem Anschluss bestehen. Solarmodule sind als flexible und starre Ausführung verfügbar. Besonders bevorzugt sind starre Photovoltaikmodule (welche beispielsweise auf Halbleiter, wie Silizium, basieren). Photovoltaikmodule sind zumeist durch eine flächige Form gekennzeichnet, mit einer deutlich geringeren Dicke im Vergleich zur lateralen Ausdehnung (Höhe und/oder Breite).

Für das modulare Wandsystem geeignete Photovoltaikmodule sind vorteilhafterweise kommerziell erhältlich und bedürfen nicht zwingend einer gesonderten oder ggf. aufwendigen Herstellung. Kommerzielle Photovoltaikmodule insbesondere auf Basis von Siliziumsolarzellen liegen zumeist auch bereits innerhalb eines Stützrahmens vor. In bevorzugten Ausführungsformen können die Stützrahmen auch entsprechend des gesamten Photovoltaikmoduls gefertigt und mühelos in ein entsprechend ausgestaltetes Kantprofil eingebracht werden. Geeignete Verfahren zum Verschweißen, Verkleben oder Verschrauben sind dem Experten bekannt.

Von dem Kantprofil erstrecken sich zwei oder mehr Ausleger, bevorzugt in einem im Wesentlichen senkrechten Winkel in Bezug auf die Längsrichtung der Kantprofile. Bei Einführung der Ausleger in die horizontalen Durchbohrungen werden sich die Kantprofile somit nahtlos an die Frontfläche des Wandsegmentes fügen. Der Winkel der Ausleger zu den Photovoltaikmodulen definiert den Neigungswinkel und kann beispielsweise bevorzugt zwischen 90° und 120° betragen.

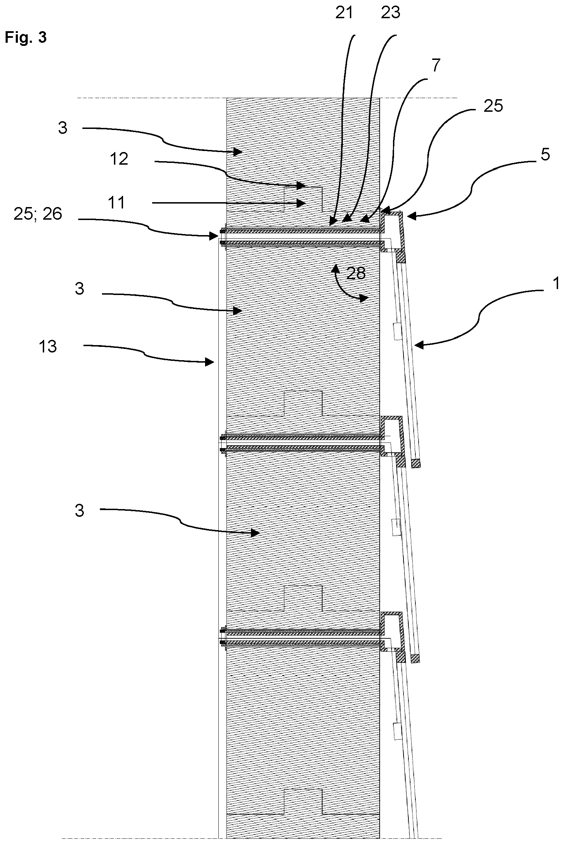

In einer bevorzugten Ausführungsform beträgt der Öffnungswinkel zwischen den Auslegern und dem Photovoltaikmodul zwischen 90° und 120°, besonders bevorzugt 95° - 105°, sodass bei dem montierten Wandsystem die Photovoltaikmodule einen Neigungswinkel zwischen 60° und 90° aufweisen. Der Öffnungswinkel zwischen Ausleger und dem Photovoltaikmodul kann vorteilhafterweise mittels der Anbringung des Photovoltaikmoduls am Kantprofil in der Planung und Vorfertigung festgelegt werden. Bevorzugt ist eine leicht schräg nach unten erfolgte Anbringung, sodass ein Winkel von über 90°, beispielsweise von 95° - 105° eingestellt wird. Dies dient der optimierten Ausnutzung der Sonnenenergie sowie der besseren Ableitung von Niederschlagswasser (vgl. Fig. 3).

Jedes Kantprofil umfasst bevorzugt zwei oder mehr Ausleger, beispielsweise als rohr- oder stangenförmige Körper. Hierdurch wird ein Rotieren bzw. Verkippen der Photovoltaikmodule verhindert und eine statische Stabilität gewährleistet. Die zwei oder mehr Ausleger können in zwei oder mehr komplementäre Durchbohrungen innerhalb eines Massivbauelementes eingeführt werden. Es kann aber auch bevorzugt sein, dass die zwei oder mehr Ausleger in jeweils eine Durchbohrung zweier nebeneinander angeordneter Massivbauelemente eingeführt werden.

Erfindungsgemäß liegen die Ausleger in Form eines Hohlprofils vor. Ein Hohlprofil bezeichnet bevorzugt einen rohrförmigen Hohlkörper mit konzentrischem, rechteckigem, ovalem oder anderem geschlossenen Querschnitt, dessen Wand aus einem festen Material, beispielsweise einem Metall, besteht.

Vorteilhafterweise kann durch die Ausleger in Form eines Hohlprofils die Ableitung eines stromführenden Kabels von den Photovoltaikmodulen zu einer Innenseite des modularen Wandsystems erfolgen. Bevorzugt liegt bei dem modularen Wandsystem das Photovoltaikmodul an einer Außenseite angebracht vor, während die stromführenden Kabel vom Photovoltaikmodul über das Kantprofil innerhalb der Hohlprofile zu einer Innenseite des modularen Wandsystems geführt werden. Die Ausleger bzw. Hohlprofile dienen somit sowohl der Kabelführung der Photovoltaikmodule als auch der Halterung der Photovoltaikmodule.

Bemerkenswert ist zudem, dass bei der erfindungsgemäßen Montage der Photovoltaikmodule deren stromführende Kabel unweigerlich geschützt vor Feuchtigkeit oder Witterung innerhalb der Hohlprofile vorliegen. Eine, wenn auch nur teilweise, Führung der Kabel entlang der Außenwände, wie diese im Stand der Technik verbreitet ist, kann vorteilhafterweise grundsätzlich vermieden werden.

Zudem sind die Photovoltaikmodule bevorzugt durch eine Mischform von integrativem und additivem Einbau gekennzeichnet. Die Photovoltaikmodule sind sowohl integrativ hinsichtlich der Kabelführung in der Gebäudehülle als auch additiv dahingehend, dass die Photovoltaikmodule vor der Gebäudehülle installiert werden.

In einer bevorzugten Ausführungsform sind die Ausleger in Form eines Hohlprofils von einer Dämmung eingehüllt. Beispielsweise können geschäumte Kunststoffe wie Polystyrol, Polyurethan (PUR), Polyisocyanurat (PIR), Phenolharz (PF), Polyethylen, geschäumte Elastomere, mineralische Fasern, wie Mineralwolle (MW), Glaswolle oder Hochtemperaturwolle, mineralische Schäume aber auch pflanzliche Rohstoffe wie Holzfasern, Holzwolle, Hanffaser, Flachsfaser oder tierische Faser verwandt werden. Die Dämmung kann in Form einer Manschette aus einem Dämmstoff um die Hohlprofile angeordnet werden, wodurch eine Kältebrücke effektiv verhindert werden kann.

Ein weiterer besonderer Vorteil der Konstruktion des modularen Wandsystems ist es, dass die mittels der Hohlprofile nach innen geführten Kabel stets auch von der Gebäudeinnenseite erreichbar sind. Demgemäß ist eine witterungsunabhängige Instandsetzung oder Montage gegeben. Nach erfolgtem Aufbau einer oder mehrerer Wandsegmente zur Errichtung einer Gebäudehülle und Installation der Photovoltaikmodule auf beschriebene Weise, können sämtliche weitergehende elektrische Anschlüsse, Einstellungen oder Installationen bequem innenseitig vorgenommen werden. Durch die deutlich vereinfachte Montage und witterungsunabhängige elektrische Verkabelung lassen sich die Bauzeiten und mithin Baukosten deutlich reduzieren.

Bevorzugt können beispielsweise sowohl die Massivbauelemente als auch die Photovoltaikmodule bereits eingefasst in die Kantprofile an einer zentralen Fertigungsstelle bereitgestellt werden. In Bezug auf die Photovoltaikmodule liegen die stromführenden Kabel bevorzugt ebenfalls bereits in den Hohlprofilen eingeführt vor.

Am gewünschten Bauort wird mithin das modulare Wandsystem bevorzugt in Form von einem Set von Massivbauelementen sowie komplementären Photovoltaikmodulen angeliefert. Alternativ können die Photovoltaikmodule mittels der Ausleger sich vorinstalliert in den Massivbauelementen befinden.

Der Errichtung eines tragenden Wandsegmentes aus gelieferten modularen Komponenten ergibt sich in beschriebener Weise auf sichere, reproduzierbare Weise und mit geringem Aufwand. Der Aufbau kann sowohl manuell, als auch roboterunterstützt erfolgen, wodurch sich Zeit- und Personalkosten sparen lassen.

Das erfindungsgemäße modulare Wandsystem erlaubt somit eine überaus effektive, einfache und stabile Integration von Photovoltaikmodulen bei der Erstellung von Gebäudewänden.

In einer bevorzugten Ausführungsform weisen die Massivbauelemente eine Länge von 200 mm bis 2000 mm, bevorzugt von 400 bis 1000 mm, besonders bevorzugt von 500 mm bis 875 mm auf.

In einer bevorzugten Ausführungsform weisen die Massivbauelemente eine Höhe von 100 mm bis 1000 mm, bevorzugt 150 bis 600 mm, besonders bevorzugt von 200 bis 400 mm, ganz besonders bevorzugt von ca. 250 bis 300 mm auf.

In einer bevorzugten Ausführungsform weisen die Massivbauelemente eine Dicke von 100 mm bis 500 mm, bevorzugt 150 bis 360 mm, besonders bevorzugt von 170 bis 360 mm auf.

Die vorgenannten Abmaße führen insbesondere bei der Verwendung von Vollholz, zu einer optimalen Lastverteilung und Lastaufnahmefähigkeit, bei gleichzeitig geringem Materialbedarf.

In einer bevorzugten Ausführungsform weisen die Massivbauelemente an gegenüberliegenden Ober- und Unterseiten jeweils formschlüssige Nuten und Federn zur Ausbildung einer Steckverbindung in vertikaler Bauweise auf. Bevorzugt handelt es sich um auskragende Federn, welche beispielsweise zentral mittig sich im Massivbauelement an einer Oberseite entlang der gesamten Länge erstrecken. Die Feder kann verschiedene Querschnittsformen aufweisen beispielsweise rechteckig, dreieckig, rund, bevorzugt ist jedoch eine rechteckige, nahezu quadratische Querschnittsform. Als Höhe haben sich für die Feder beispielsweise Werte von 2 bis 10 cm als bevorzugt erwiesen. Die Nuten sind passgenau auf die Federn ausgestaltet, sodass bei vertikaler Positionierung der Massivbauelemente übereinander ein Form- und/oder Kraftschluss erfolgt.

Massivbauelemente, welche für den Mittelteil des Wandsegmentes vorgesehen sind, umfassen bevorzugt an einer Ober- bzw. Unterseite eine Feder und an der gegenüberliegenden Unter- bzw. Oberseite eine Nut. Die vertikale Steckbauweise mittels Nuten und Federn hat sich insbesondere für Massivbauelemente aus Vollholz als eine einfache Montagelösung bewährt, welche sich zudem durch höchste Stabilität auszeichnet.

In einer bevorzugten Ausführungsform sind die Massivbauelemente aus Vollholz gefertigt.

Die Verwendung von Vollholz ist besonders bevorzugt, da diese ein gesundes Raumklima, eine hohe Lebensdauer, günstige Wartungskosten, Umweltfreundlichkeit und einfache Verfügbarkeit des Materials bietet. Auch die Energie- und Wärmebilanz ist bei einer modularen Bauweise aus Vollholz ausgezeichnet. Hinsichtlich des Brandschutzes weisen Massivbauelemente aus Vollholz einen wichtigen Vorteil gegenüber den ansonsten weit verbreiteten dünnen Schalungsbrettern auf. Insbesondere erlauben massive Holzbauelemente eine Form des Holzbaus, mit dem Feuerwiderstandsklassen bis F90 erreicht werden können.

Massivbauelemente aus Vollholz können beispielsweise in Längsrichtung quaderförmig aus einem hinreichend großen Baumstamm geschnitten werden. Es kann aber auch bevorzugt sein, beispielsweise zwei, drei oder mehr massive Holzquader zu einem massiven Vollholzelement zu verleimen oder zu verkleben. Die Festigkeitswerte von Holz sind entsprechend der gewachsenen Struktur in Faserlängsrichtung ausgezeichnet. Die Kraftübertragung in das Holz erfolgt bevorzugt durch den Druck parallel zur Faser über die vorhandenen Kontaktflächen, wodurch sich eine belastbare Statik ergibt.

Während die modulare Bauweise mittels Vollholz eine besonders bevorzugte Ausführungsform der Erfindung dargestellt, können vorteilhafterweise auch andere Baustoffe verwendet werden.

In einer bevorzugten Ausführungsform der Erfindung sind die Massivbauelemente aus Ziegelstein gefertigt.

In einer bevorzugten Ausführungsform der Erfindung sind die Massivbauelemente aus Beton gefertigt.

In einer weiteren bevorzugten Ausführungsform der Erfindung umfasst das modulare Wandsystem mindestens vier, bevorzugt mindestens 6, 8, 10 oder mehr Massivbauelemente, wobei zur Ausbildung einer Reihe von Massivbauelementen zwei oder mehr Massivbauelemente horizontal verbunden werden und zwei oder mehr solcher Reihen vertikal übereinander angeordnet werden.

Das modulare Wandsystem zeichnet sich durch die hohe Flexibilität eines Baukastenprinzips aus und ermöglicht die Errichtung von Wandsegmenten in gewünschten Maßen und Formen. Hierzu werden die Massivbauelemente bevorzugt sowohl in horizontaler als auch vertikaler Richtung miteinander verbunden.

Für die vertikale Verbindung, können wie obig bereits erläutert, formschlüssige Federn und Nuten an gegenüberliegenden Ober- bzw. Unterseiten vorgesehen sein.

Für die horizontale Verbindung kann es ebenso bevorzugt sein, dass die Massivbauelemente an gegenüberliegenden Querseiten jeweils formschlüssige Nuten und Federn zur Ausbildung einer Steckverbindung in horizontaler Bauweise aufweisen. Hierdurch kann eine stabile Steckverbindung in Längsrichtung der Massivbauelemente erzielt werden.

Es kann auch bevorzugt sein eine Feder sowohl für die horizontale sowie vertikale Steckverbindung zu verwenden. Die Feder kann beispielsweise nahezu über die gesamte Länge des Massivbauelementes verlaufen und sowohl in der Höhe als auch seitlich auskragen.

Neben den horizontalen sowie vertikalen Steckverbindungen können auch weitere Befestigungsmittel vorgesehen werden, um einen besonders stabilen Verbund der Massivbauelemente zu erhalten und die Ausbildung einer selbsttragenden Wand zu unterstützen.

In einer bevorzugten Ausführungsform der Erfindung weisen die Massivbauelemente in vertikaler Richtung eine Sacklochbohrung und eine Durchgangsbohrung auf, sodass bei einem versetzten Aufeinandersetzen der Massivbauelemente jeweils das Sackbohrloch eines unteren Massivbauelementes mit einer Durchgangsbohrung eines darüber angeordneten Massivbauelementes bündig ausgerichtet ist. Durch die Durchgangsbohrungen kann ein stabförmiges Befestigungsmittel, beispielsweise eine Schraube, geführt werden und die vertikal übereinander angeordneten Massivbauelemente fixieren.

Beispielsweise kann das Sackbohrloch ein Schraubgewinde umfassen und bevorzugt von einer Oberseite des Massivbauelementes senkrecht nach unten verlaufen und in Bezug auf die Länge wie Tiefe mittig angeordnet sein. Die vertikale oder senkrechte Durchbohrung kann beispielsweise in Bezug auf die Tiefe ebenfalls mittig, aber in Bezug auf die Länge des Massivbauelementes endseitig angeordnet vorliegen. Auch die Durchgangsbohrung kann ein Schraubgewinde aufweisen.

Ein Verbund aus Massivbauelementen, welche einerseits auf einer Verzahnung von Nuten und Federn sowie andererseits einer zusätzlichen Fixierung durch bündige Schrauben in Durchgangslöchern bzw. Sacklöchern basiert, hat sich als statisch überaus stabil erwiesen. Mittels dieser Ausführungsform kann auf zuverlässige Weise ein äußerst belastbares Wandsegment unter geringem Montage- wie Materialaufwand bereitgestellt werden.

In einer bevorzugten Ausführungsform sind die Massivbauelemente in Längsrichtung gerade, sodass daraus resultierend ein gerades Wandsegment erhalten werden kann. Durch derartige gerade Massivbauelemente können auf bekannte Weise eckige, beispielsweise rechteckige Gebäudehüllen aufgestellt werden.

Vorteilhafterweise ist das modulare Wandsystem nicht auf einer derartigen geraden Bauweise beschränkt, sondern kann zudem unter Verwendung gekrümmter Massivbauelemente eine beliebig gekrümmte Gebäudehülle aufweisen.

In einer bevorzugten Ausführungsform weisen zwei oder mehr Massivbauelemente eine Krümmung auf, sodass das modulare Wandsystem zur Errichtung einer gekrümmten Wand geeignet ist. Vorteilhafterweise lässt sich mittels dieser Ausführungsform ein mehrgeschossiges Bauwerk mit einer gekrümmten Gebäudehülle rund oder elliptisch herstellen.

Gerade bei der Verwendung von Vollholz hat die gekrümmte Bauweise, gegenüber geraden Holzbausystemen deutliche Vorteile bzgl. der Energiebilanz, Wärmedämmung, Brandschutz und ist zudem besonders formstabil.

Ein gekrümmtes Wandsegment, bzw. eine gekrümmte Gebäudehülle, kann bevorzugt aus kleinformatigen, gekrümmten Massivbauelementen gebildet werden. Ein Haus mit quadratischem oder rechteckigem Grundriss benötigt mehr Baumaterial als ein rundes Haus. Bedingt hierdurch folgen für den Lebenszyklus von quadratischen Häusern auch höhere Heiz- oder Kühlkosten im Vergleich zur bevorzugten, gekrümmten Variante.

Bevorzugt weisen die gekrümmten Massivbauteile einen im Wesentlichen identische Dicke bzw. Tiefe auf, sodass ein Wandsegment mit gleichmäßiger Wandstärke erhalten wird. Die Beanspruchung des selbsttragenden Wandsegmentes ist daher überall gleichmäßig.

Begriffe wie im Wesentlichen, ungefähr, etwa, ca. etc. beschreiben bevorzugt einen Toleranzbereich von weniger als ± 20%, bevorzugt weniger als ± 10 %, noch stärker bevorzugt weniger als ± 5% und insbesondere weniger als ± 1%. Angaben von im Wesentlichen, ungefähr, etwa, ca. etc. offenbaren und umfassen stets auch den exakten genannten Wert.

Zur Ausbildung eines Verbundes aus 4, 6 oder mehr Massivbauelementen können bei gekrümmten Massivbauelementen diese radial übereinander im Verbund gelagert werden. Entsprechend ihrer Form können diese ebenfalls gekrümmte Nut- und Federkonstruktionen zur Ausbildung von Steckverbindungen aufweisen. Eine gekrümmt verlaufende Feder kann mittig nach oben sowie zu einer Seite des Massivbauelementes auskragen. Die versetzt liegende Nut des versetzt darüber bzw. darunter liegenden Elementes kann die gekrümmten Federn aufnehmen. Auf diese Weise können auch bei einer gekrümmten Bauweise die Elemente form- und kraftschlüssig horizontal und vertikal miteinander verbunden werden. Die gekrümmte Feder kann verdeckt mittig in den Massivbauelementen vorliegen und so hinter und vor einer inneren und äußeren Fuge liegen. Hierdurch werden die Transmissionswärmeverluste weiter reduziert. Die beiden Enden der Massivbauelemente können auch quer tangential geschnitten sein.

Ein Sackbohrloch mit Schraubgewinde kann sich in der Mitte der gekrümmten Feder und eine Durchgangsbohrung mit Schraubgewinde mittig am Ende einer gekrümmten Feder zur Aufnahme von Schrauben, beispielsweise aus Holz, Metall oder Kunststoff befinden.

In einem weiteren Aspekt betrifft die Erfindung auch ein Gebäude, umfassend mindestens eine Wand, welche von einem beschriebenen modularen Wandsystem gebildet wird.

Bevorzugt handelt es sich bei der Wand, um eine Außenwand des Gebäudes, ganz besonders bevorzugt um eine statisch tragende Außenwand. Der Begriff "statisch tragend" wird wie im Bauwesen üblich verwendet und kennzeichnet Wände, welche essentiell für die Statik des Gebäudes sind und somit eine erhöhte Lastaufnahmefähigkeit vorweisen müssen.

Im Folgenden soll die Erfindung an Hand von Beispielen näher erläutert werden, ohne auf diese beschränkt zu sein.

### Kurzbeschreibung der Abbildungen

- **Fig. 1**: Schematische 3D-Ansicht einer bevorzugten Ausführungsform eines Massivbauelementes aus Vollholz, an welchem ein Photovoltaikmodul angebracht vorliegt.
- **Fig. 2**: Schematische 3D-Ansicht einer bevorzugten Ausführungsform eines Massivbauelementes aus Vollholz zur Aufnahme eines Photovoltaikmodules.
- **Fig. 3**: Schematischer Vertikalschnitt einer bevorzugten Ausführungsform eines modularen Wandsystems mit Massivbauelement aus Vollholz und angebrachten Photovoltaikmodulen.
- **Fig. 4**: Schematische Illustration der Montage von Photovoltaikmodulen in Massivbauelementen eines modularen Wandsystems
- **Fig. 5**: Schematische Illustration zur Einstellbarkeit verschiedener Neigungswinkel des Photovoltaikmodules
- **Fig. 6**: Schematischer Horizontalschnitt einer bevorzugten Ausführungsform eines Massivbauelementes aus Vollholz, an welchem ein Photovoltaikmodul angebracht vorliegt.
- **Fig. 7**: Schematischer Horizontalschnitt einer bevorzugten Ausführungsformen von **A** geraden Massivbauelementen aus Vollholz zur Aufnahme von Photovoltaikmodulen und **B** einer Kombination aus geraden und gekrümmten Massivbauelementen aus Vollholz zur Errichtung von gekrümmten Wänden.
- **Fig. 8**: Schematische 3D-Ansicht einer bevorzugten Ausführungsform eines modularen Wandsystems mit Massivbauelementen aus Vollholz zur Aufnahme von Photovoltaikmodulen.
- **Fig. 9**: Schematische 3D-Ansicht einer bevorzugten Ausführungsform eines Massivbauelementes aus Ziegelsteinen, an welchem ein Photovoltaikmodul angebracht vorliegt.
- **Fig. 10**: Schematische 3D-Ansicht einer bevorzugten Ausführungsform eines Massivbauelementes aus Stahlbeton, an welchem ein Photovoltaikmodul angebracht vorliegt.

### Detaillierte Beschreibung der Abbildungen

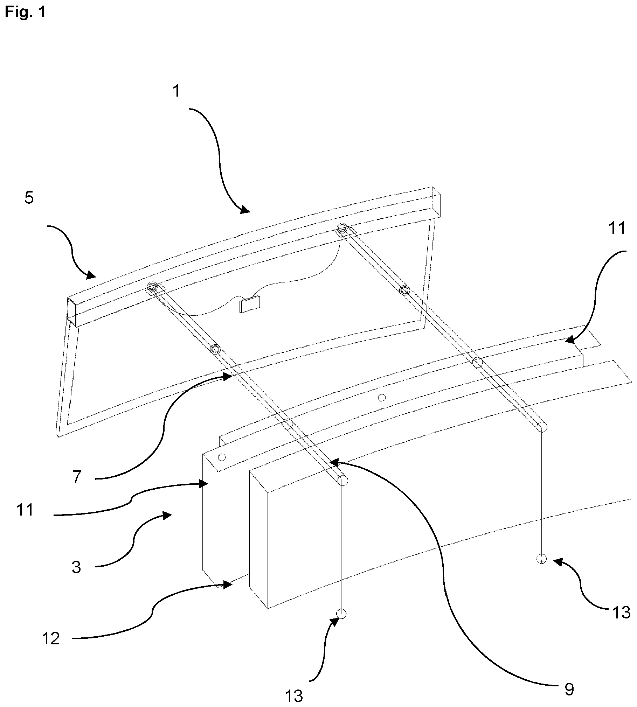

Figur 1 zeigt eine schematische 3D-Ansicht einer bevorzugten Ausführungsform eines Massivbauelementes **3** aus Vollholz, an welchem ein Photovoltaikmodul **1** angebracht vorliegt. Das Photovoltaikmodul **1** liegt mit einer Längsseite in einem Kantprofil **5** montiert vor. Das Kantprofil **5** weist zudem zwei Ausleger **7** auf, welche in der dargestellten bevorzugten Ausführungsform runde Hohlprofile sind. Das Kantprofil **5** sowie Ausleger bzw. Hohlprofile **7** können bevorzugt aus einem Metall gefertigt sein. Zur Montage des Photovoltaikmodules **1** am Massivbauelement **3,** weist das Massivbauelement **3** zwei horizontale Durchgangsbohrlöcher **9** auf, deren Dimensionierung an die Ausleger **7** angepasst ist. Die Montage kann durch einfaches Einführen der Ausleger **7** in entsprechende Durchbohrungslöcher **9** erfolgen. Vorteilhafterweise können die stromführenden Kabel **13** vom Photovoltaikmodul **1** innerhalb der Ausleger bzw. Hohlprofile **7** auf eine Innenseite des modularen Wandsystems geführt werden. Die Ausleger bzw. Hohlprofile **7** dienen somit sowohl der Halterung der Photovoltaikmodule **1** als auch einer geschützten Führung der Stromkabel **13.**

Für eine vertikale und horizontale form- und/oder kraftschlüssige Verbindung mit anderen Massivbauelementen **3** zur Errichtung eines Wandsegmentes sind sowohl auf den gegenüberliegenden Ober- und Unterseiten, als auch auf gegenüber liegenden Querseiten jeweils Federn **11** bzw. Nuten **12** angeordnet. In der gezeigten Ausführungsform verläuft die Feder **11** nahezu über die gesamte Länge des Massivbauelementes **3** und kragt sowohl in der Höhe als auch seitlich aus, sodass an den gegenüberliegenden Seiten zudem Nuten **12** gebildet werden.

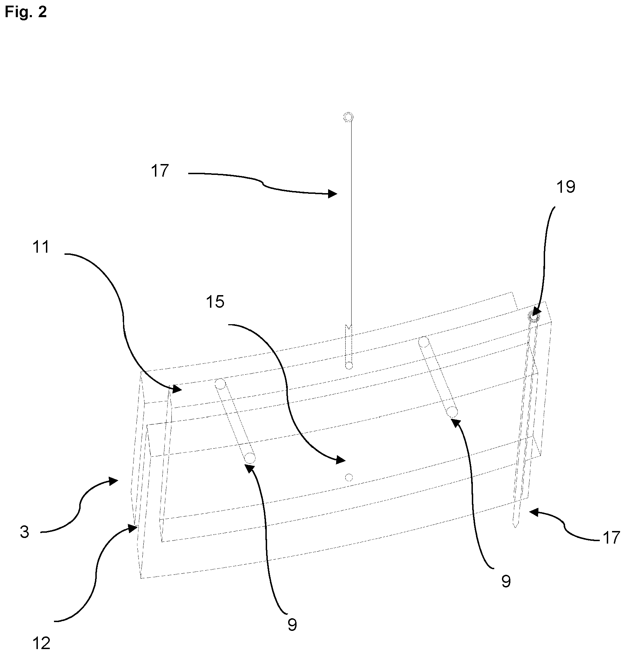

Figur 2 zeigt eine schematische 3D-Ansicht einer bevorzugten Ausführungsform eines Massivbauelementes **3** aus Vollholz zur Aufnahme eines Photovoltaikmodules (nicht gezeigt). Analog zur Ausführungsform der Figur **1** weist das Massivbauelement **3** zu diesem Zweck horizontale Durchbohrungen **9** auf. Weiterhin liegen ebenso wie in der Figur **1** Federn **11** bzw. Nuten **12** an gegenüberliegenden Ober- und Unterseiten sowie Querseiten vor. Auch hier verläuft die Feder **11** nahezu über die gesamte Länge des Massivbauelementes **3** und kragt sowohl in der Höhe als auch seitlich aus.

Darüber hinaus illustriert die Figur 2 das bevorzugte Vorliegen von Sacklochbohrungen **15** und Durchgangsbohrungen **19** in vertikaler Richtung. Bei einem versetzten Aufeinandersetzen der Massivbauelemente **3** kann jeweils das Sackbohrloch **15** eines unteren Massivbauelementes **3** mit einer Durchgangsbohrung **19** eines darüber angeordneten Massivbauelementes **3** bündig ausgerichtet werden. Ein stabförmiges Befestigungsmittel **17** kann durch die Durchgangsbohrungen **19** geführt werden und die vertikal übereinander angeordneten Massivbauelemente **3** zusätzlich fixieren.

Figur 3 zeigt einen schematischen Vertikalschnitt einer bevorzugten Ausführungsform eines modularen Wandsystems mit Massivbauelement **3** aus Vollholz und angebrachten Photovoltaikmodulen **1.** Mittels ineinandergreifenden Federn **11** und Nuten **12** werden die Massivbauelemente **3** vertikal übereinander angeordnet und miteinander verbunden.

In jedem Massivbauelement **3** liegen Durchgangsbohrungen **9** zur entsprechenden Aufnahme der Ausleger bzw. Hohlprofile **7** vor. Die Photovoltaikmodule **1** sind in einem Kantprofil **5** eingefasst, von welchem die Ausleger **7** sich im Wesentlichen rechtwinklig erstrecken. Der Öffnungswinkel **28** zwischen dem Photovoltaikmodul und den Auslegern liegt bei ungefähr 95°, sodass ein Neigungswinkel von ca. 85° erhalten und Nässe optimal abgeführt werden kann. Innerhalb der Hohlprofile **7** werden die stromführenden Kabel **13** geschützt auf die Innenfläche des Wandsegmentes geführt. Hierbei kann bevorzugt eine Parallelschaltung der Photovoltaikmodule **1** vorgenommen werden.

Die Ausleger bzw. Hohlprofile **7** sind von einer Dämmung in Form **21** einer Manschette eingehüllt, wodurch eine Kältebrücke verhindert wird. Unterstützend kann zu diesem Zweck auch eine Luftschicht **23** vorgesehen sein. Die Hohlprofile weisen an der zur Innenwand gewandten Seite am Ende ein Schraubgewinde auf **26.** Unterlegscheiben bzw. Mutter **25** gewährleisten eine pass- und abstandgenaue Montage.

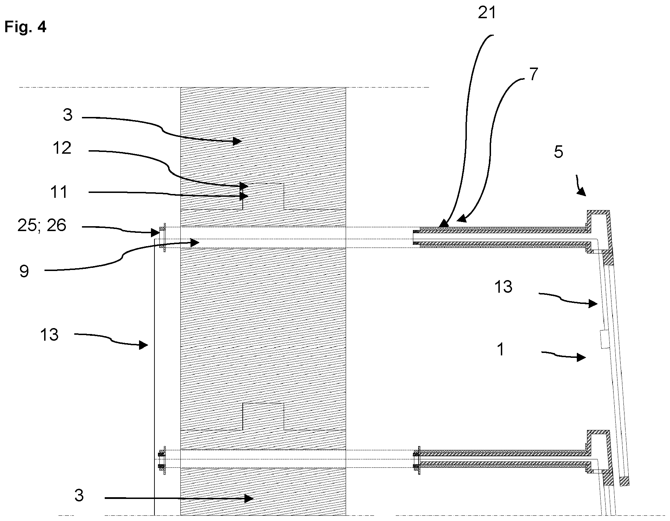

Figur 4 illustriert schematisch eine Montage von Photovoltaikmodulen **1** in Massivbauelemente **3** eines modularen Wandsystems. Bei Bereitstellung entsprechend vorbereiteter und eingefasster Photovoltaikmodule **1** kann die Montage durch Einführen der Ausleger bzw. Hohlprofile **7** in die entsprechenden Durchgangsbohrungen **9** auf überaus einfache Weise erfolgen.

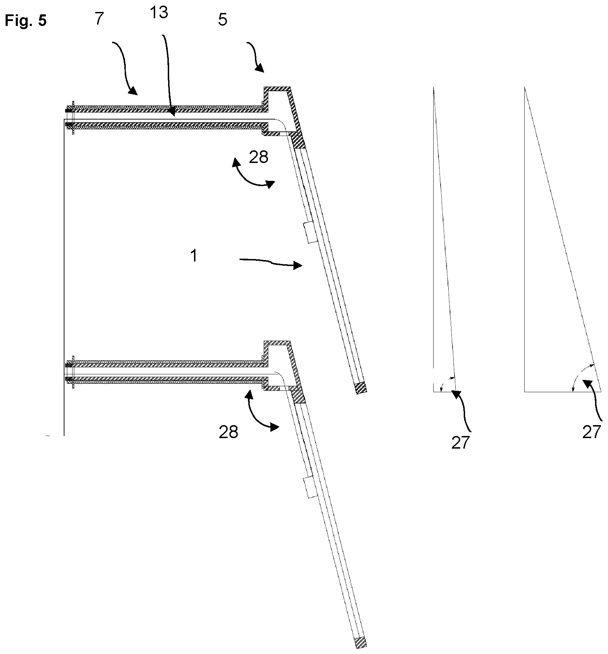

Figur 5 illustriert schematisch die Einstellbarkeit verschiedener Neigungswinkel **27** eines Photovoltaikmodules **1** an einem vertikalen Wandsegment. Der Neigungswinkel **27** wird durch den Öffnungswinkel **28** zwischen den Auslegern bzw. Hohlprofilen **7** und den Photovoltaikmodulen bestimmt, wobei die Beziehung Neigungswinkel **27** = 180° - Öffnungswinkel **28** gilt. Als beispielhaft bevorzugte Neigungswinkel **27** werden ca. 85° bzw. 75° gezeigt, welche durch Öffnungswinkel **28** von 95° bzw. 105° realisiert werden können.

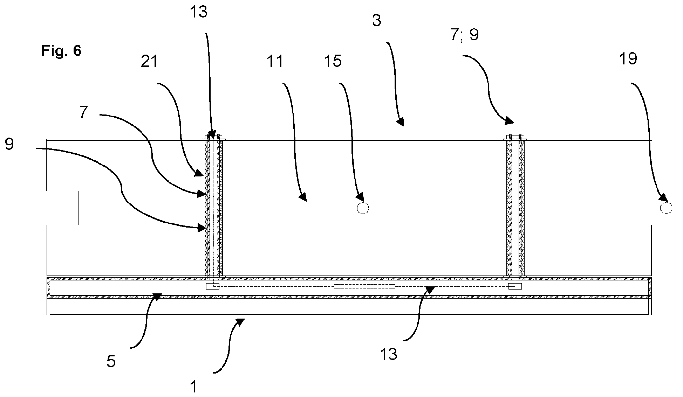

Figur 6 zeigt einen schematischen Horizontalschnitt bzw. die Draufsicht auf eine bevorzugte Ausführungsform eines Massivbauelementes **3** aus Vollholz, an welchem ein Photovoltaikmodul **1** angebracht vorliegt. Durch die Einführung der Ausleger bzw. Hohlprofile **7** in die entsprechenden Durchbohrungen **9** fügt sich das Kantprofil **5** nahtlos an Front- bzw. Außenfläche des Massivbauelementes **3** an.

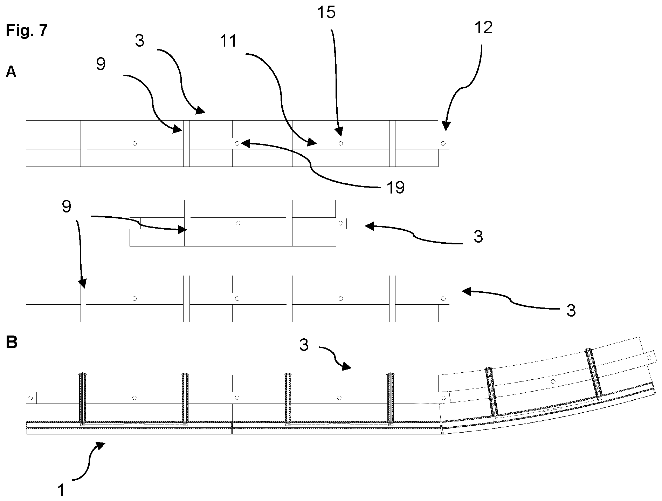

Figur 7A zeigt einen schematischen Horizontalschnitt einer bevorzugten Ausführungsform von geraden Massivbauelementen **3** aus Vollholz zur Aufnahme von Photovoltaikmodulen. Zur horizontalen Verbindung und Ausbildung einer Reihe hintereinander verbundener Massivbauelemente **3** weisen die Massivbauelemente an gegenüberliegenden Querseiten entsprechende Federn **11** und Nuten **12** auf.

Figur 7 B illustriert eine bevorzugte Kombination aus geraden und gekrümmten Massivbauelementen **3** aus Vollholz zur Errichtung von gekrümmten Wänden. Die Federn **11** und Nuten **12** folgen der Krümmung.

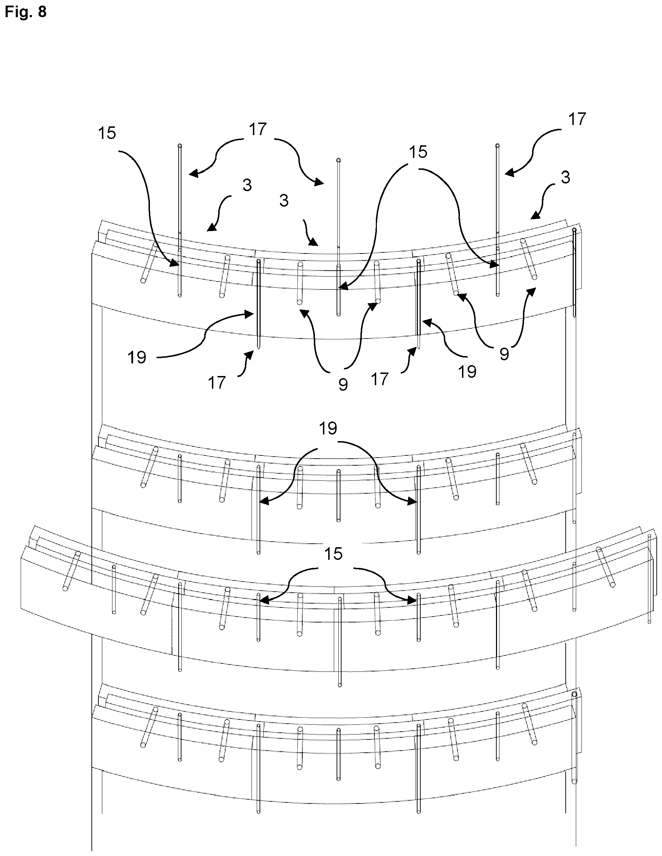

Figur 8 zeigt eine schematische 3D-Ansicht einer bevorzugten Ausführungsform eines modularen Wandsystems mit Massivbauelementen **3** aus Vollholz zur Aufnahme von Photovoltaikmodulen **1.** Die Massivbauelemente **3** wurden sowohl horizontal als auch vertikal mittels Nuten und Federn (nicht gezeigt) miteinander verbunden. Zur weiteren Fixierung dienen Befestigungsmittel **17,** Durchgangsbohrungen **19** und Sacklochbohrungen **15.**

Die Sacklochbohrungen **15** und die Durchgangsbohrungen **19** liegen in den Massivbauelementen in vertikaler Richtung vor. Das Sackbohrloch verläuft von einer Oberseite eines Massivbauelementes **3** senkrecht nach unten und ist in Bezug auf die Längs-, wie Querrichtung des Massivbauelementes **3** mittig angeordnet. Die vertikale Durchbohrung **19** kann beispielsweise in Bezug auf die Querrichtung ebenfalls mittig, aber in Bezug auf die Längsrichtung des Massivbauelementes **3** an einer Endseite vorliegen. Bei einem versetzten Aufeinandersetzen der Massivbauelemente **3** sind wie gezeigt jeweils die Sacklochbohrung **15** eines unteren Massivbauelementes **3** mit einer Durchgangsbohrung **19** eines darüber angeordneten Massivbauelementes **3** bündig ausgerichtet. Durch die Durchgangsbohrungen **19** kann somit ein stabförmiges Befestigungsmittel **17** beispielsweise eine Schraube geführt werden, um die vertikal übereinander angeordneten Massivbauelemente **3** zu fixieren.

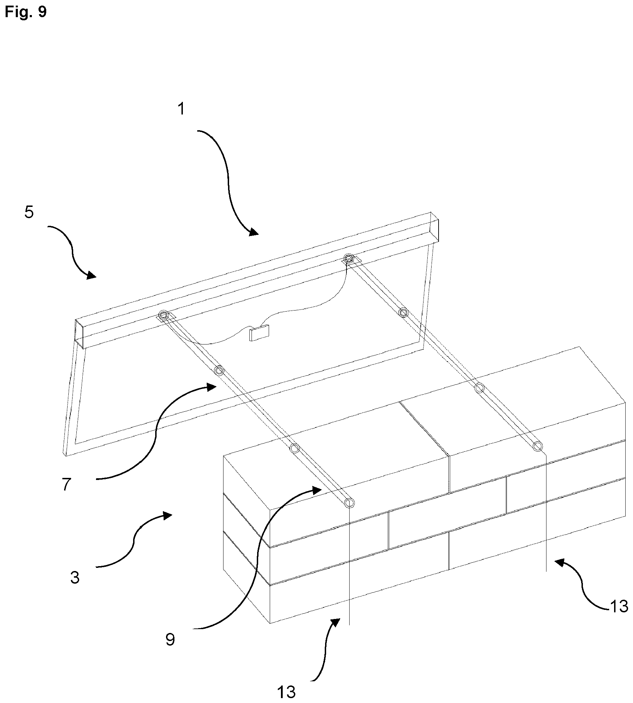

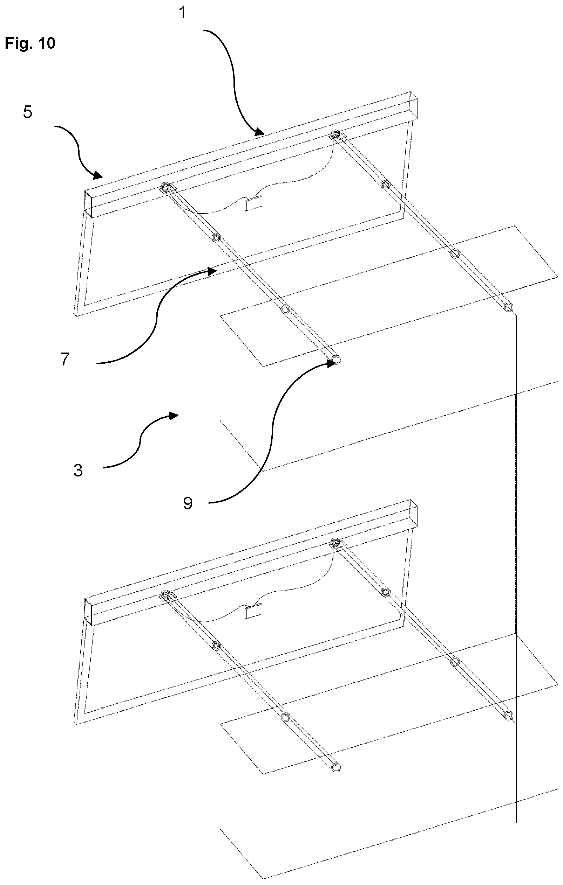

Figur 9 und 10 zeigen jeweils analog zur Figur 1 eine schematische 3D-Ansicht einer bevorzugten Ausführungsform eines Massivbauelementes **3,** an welchem ein Photovoltaikmodul **1** angebracht vorliegt. In Figur 9 wird Ziegelstein als Material für die Massivbauelemente **3** verwendet, während in Fig. 10 Massivbauelemente **3** aus Beton bzw. Stahlbeton gezeigt werden. In Fig. 10 wird zudem eine Parallelschaltung der Photovoltaikmodule **1** mittels der stromführenden Kabel **13** illustriert.

Es wird darauf hingewiesen, dass verschiedene Alternativen zu den beschriebenen Ausführungsformen der Erfindung verwendet werden können, um die Erfindung auszuführen und zu der erfindungsgemäßen Lösung zu gelangen. Das erfindungsgemäße modulare Wandsystem beschränkt sich in den Ausführungen somit nicht auf die vorstehenden bevorzugten Ausführungsformen. Vielmehr ist eine Vielzahl von Ausgestaltungsvarianten denkbar, welche von der dargestellten Lösung abweichen können. Ziel der Ansprüche ist es, den Schutzumfang der Erfindung zu definieren und das erfindungsgemäße modulare Wandsystem sowie äquivalente Ausführungsformen von diesem abzudecken.

### Bezugszeichenliste

- 1: Photovoltaikelement
- 3: Massivbauelement
- 5: Kantprofil
- 7: Ausleger in Form eines Hohlprofils mit Verschraubung am Ende, zur Innenwand geführten Seite
- 9: horizontale Durchgangsbohrlöcher zur Aufnahme der Hohlprofile
- 11: Feder (auskragend)
- 12: Nut
- 13: Kabel zur Stromabführung
- 15: vertikale Sacklochbohrung
- 17: Befestigungsmittel (z.B. Schraube) aus Metall, Holz oder Kunststoff für Sacklochbzw. Durchgangsbohrungen

- 19: vertikale Durchgangsbohrungen
- 21: Dämmung
- 23: Luftschicht
- 25: Unterlegscheibe bzw. Mutter
- 26: Schraubgewinde
- 27: Neigungswinkel des Photovoltaikmodules
- 28: Öffnungswinkel zwischen Photovoltaikelement und Ausleger bzw. Hohlprofil

## Patentansprüche

1. Modulares Wandsystem umfassend
a) Massivbauelemente (3) zur modularen Errichtung selbsttragender Wandsegmente und
b) Photovoltaikmodule (1)
**dadurch gekennzeichnet, dass**
die Massivbauelemente (3) eine oder mehrere Durchbohrungen (9) zur Halterung der Photovoltaikmodule (1) aufweisen, wobei die Photovoltaikmodule (1) in Kantprofilen (5) montiert vorliegen, welche zwei oder mehr Ausleger (7) zur Einführung in die Durchbohrungen (9) der Massivbauelemente aufweisen und wobei die Ausleger (7) in Form eines Hohlprofils vorliegen und die Ableitung eines stromführenden Kabels (13) von den Photovoltaikmodulen (1) zu einer Innenseite des modularen Wandsystems erlauben.

2. Modulares Wandsystem gemäß dem vorherigen Anspruch
**dadurch gekennzeichnet, dass**
Massivbauelemente (3) an gegenüberliegenden Ober- und Unterseiten jeweils formschlüssige Nuten (12) und Federn (11) zur Ausbildung einer Steckverbindung in vertikaler Bauweise aufweisen.

3. Modulares Wandsystem gemäß einem der vorherigen Ansprüche
**dadurch gekennzeichnet, dass**
die Massivbauelemente (3) aus Vollholz, Ziegelstein oder Stahlbeton gefertigt sind.

4. Modulares Wandsystem gemäß einem der vorherigen Ansprüche
**dadurch gekennzeichnet, dass**
das modulares Wandsystem mindestens vier, bevorzugt mindestens 6, 8, 10 oder mehr Massivbauelemente (3) umfasst, wobei zur Ausbildung einer Reihe von Massivbauelementen (3) zwei oder mehr Massivbauelemente (3) horizontal verbunden werden und zwei oder mehr solcher Reihen vertikal übereinander angeordnet werden.

5. Modulares Wandsystem gemäß einem der vorherigen Ansprüche
**dadurch gekennzeichnet, dass**
die Massivbauelemente (3) an gegenüberliegenden Querseiten jeweils formschlüssige Nuten (12) und Federn (11) zur Ausbildung einer Steckverbindung in horizontaler Bauweise aufweisen.

6. Modulares Wandsystem gemäß einem der vorherigen Ansprüche
**dadurch gekennzeichnet, dass**
die Massivbauelemente (3) in vertikaler Richtung eine Sacklochbohrung (15) und eine Durchgangsbohrung (19) aufweisen, sodass bei einem versetzten Aufeinandersetzen der Massivbauelemente (3) jeweils das Sackbohrloch (15) eines unteren Massivbauelementes (3) mit einer Durchgangsbohrung (19) eines darüber angeordneten Massivbauelementes (3) bündig ausgerichtet ist.

7. Modulares Wandsystem gemäß einem der vorherigen Ansprüche
**dadurch gekennzeichnet, dass**
zwei oder mehr Massivbauelemente (3) eine Krümmung aufweisen, sodass das modulare Wandsystem zur Errichtung einer gekrümmten Wand geeignet ist.

8. Modulares Wandsystem gemäß einem der vorherigen Ansprüche
**dadurch gekennzeichnet, dass**
die Ausleger (7) in Form eines Hohlprofils von einer Dämmung (21) eingehüllt werden.

9. Modulares Wandsystem gemäß einem der vorherigen Ansprüche
**dadurch gekennzeichnet, dass**
der Öffnungswinkel zwischen den Auslegern (7) und den Photovoltaikmodulen (1) zwischen 90° und 120° beträgt, sodass bei dem montierten Wandsystem die Photovoltaikmodule einen Neigungswinkel zwischen 60° und 90° aufweisen.

10. Gebäude umfassend mindestens eine Wand
**dadurch gekennzeichnet, dass**
die Wand von einem modularen Wandsystem gemäß einem der vorherigen Ansprüche gebildet wird.

11. Gebäude gemäß dem vorherigen Anspruch
**dadurch gekennzeichnet, dass**
die Wand eine Außenwand des Gebäudes, besonders bevorzugt eine statisch tragende Außenwand des Gebäudes ist.

## Claims

1. A modular wall system, comprising
a) solid structural components (3) for the modular erection of self-supporting wall segments, and
b) photovoltaic modules (1)
**characterized in that**
the solid structural components (3) have one or more through holes (9) for holding the photovoltaic modules (1), the photovoltaic modules (1) being mounted in edge profiles (5) which have two or more cantilevers (7) for insertion into the through holes (9) of the solid structural components and wherein the cantilevers (7) are in the form of a hollow profile and allow a current-carrying cable (13) running through them from the photovoltaic modules (1) to an inside of the modular wall system.

2. The modular wall system according to the previous claim, **characterized in that**
solid structural components (3) each have form-fitting grooves (12) and tongues (11) on opposite top and bottom sides to form a plug-in connection in vertical construction.

3. The modular wall system according to any one of the preceding claims,
**characterized in that**
the solid structural components (3) are made of solid wood, brick or reinforced concrete.

4. The modular wall system according to any one of the preceding claims,
**characterized in that**
the modular wall system comprises at least four, preferably at least 6, 8, 10 or more solid structural components (3), wherein two or more solid structural components (3) are connected horizontally to form a row of solid structural components (3) and two or more such rows are arranged vertically one above the other.

5. The modular wall system according to any one of the preceding claims,
**characterized in that**
the solid structural components (3) each have form-fitting grooves (12) and tongues (11) on opposite transverse sides to form a plug-in connection in horizontal way of construction.

6. The modular wall system according to any one of the preceding claims,
**characterized in that**
the solid structural components (3) have a blind hole (15) and a through hole (19) in the vertical direction, so that when the solid structural components (3) are stacked in an offset manner, the blind hole (15) of a lower solid structural component (3) is aligned flush with a through hole (19) of a solid structural component (3) arranged above.

7. The modular wall system according to any one of the preceding claims,
**characterized in that**
two or more solid structural components (3) have a curvature, so that the modular wall system is suitable for erecting a curved wall.

8. The modular wall system according to any one of the preceding claims,
**characterized in that**
the cantilevers (7) in the form of a hollow profile are encased by insulation (21).

9. The modular wall system according to any one of the preceding claims,
**characterized in that**
the opening angle between the cantilevers (7) and the photovoltaic modules (1) is between 90° and 120°, so that the photovoltaic modules have an angle of inclination between 60° and 90° when the wall system is mounted.

10. A building, comprising at least one wall
**characterized in that**
the wall is formed by a modular wall system according to any one of the preceding claims.

11. The building according to the previous claim **characterized in that**
the wall is an outer wall of the building, particularly preferably a static load-bearing outer wall of the building.

## Revendications

1. Système mural modulaire comprenant
a) des composants solides (3) pour la construction modulaire de segments de murs autoportants et
b) des modules photovoltaïques (1)
**caractérisé en ce que**
les composants solides (3) présentent un ou plusieurs trous traversants (9) pour le maintien des modules photovoltaïques (1), dans lequel les modules photovoltaïques (1) sont montés dans des profilés de bord (5) qui présentent au moins deux bras (7) pour l'insertion dans les trous traversants (9) des composants solides et dans lequel les bras (7) sont sous la forme d'un profilé creux et permettent la dérivation d'un câble conducteur de courant (13) des modules photovoltaïques (1) vers une face intérieure du système mural modulaire.

2. Système mural modulaire selon la revendication précédente **caractérisé en ce que**
des composants solides (3) présentent chacun des rainures (12) et des languettes (11) d'ajustement de forme sur des côtés supérieurs et inférieurs opposés pour former une connexion enfichable dans une construction verticale.

3. Système mural modulaire selon l'une des revendications précédentes
**caractérisé en ce que**
les composants solides (3) sont en bois massif, en brique ou en béton armé.

4. Système mural modulaire selon l'une des revendications précédentes
**caractérisé en ce que**
le système mural modulaire comprend au moins quatre, de préférence au moins 6, 8, 10 composants solides (3) ou plus, dans lequel au moins deux composants solides (3) sont reliés horizontalement pour former une rangée de composants solides (3) et au moins deux de ces rangées sont disposées verticalement l'une au-dessus de l'autre.

5. Système mural modulaire selon l'une des revendications précédentes
**caractérisé en ce que**
les composants solides (3) présentent chacun des rainures (12) et des languettes (11) d'ajustement de forme sur des côtés supérieurs et inférieurs opposés pour former une connexion enfichable dans une construction horizontale.

6. Système mural modulaire selon l'une des revendications précédentes
**caractérisé en ce que**
les composants solides (3) présentent un trou borgne (15) et un trou traversant (19) dans la direction verticale, de sorte que lorsque les composants solides (3) sont empilés de manière décalée, le trou borgne (15) d'un composant solide (3) inférieur est à chaque fois aligné avec un trou traversant (19) d'un composant solide (3) disposé au-dessus.

7. Système mural modulaire selon l'une des revendications précédentes
**caractérisé en ce qu'**
au moins deux composants solides (3) présentent une courbure, de sorte que le système mural modulaire est conçu pour construire un mur courbé.

8. Système mural modulaire selon l'une des revendications précédentes
**caractérisé en ce que**
les bras (7) en forme de profilé creux sont entourés d'un isolant (21) .

9. Système mural modulaire selon l'une des revendications précédentes
**caractérisé en ce que**
l'angle d'ouverture entre les bras (7) et les modules photovoltaïques (1) est compris entre 90° et 120°, de sorte que les modules photovoltaïques présentent un angle d'inclinaison compris entre 60° et 90° lorsque le système mural est monté.

10. Bâtiment comprenant au moins un mur
**caractérisé en ce que**
le mur est formé par un système mural modulaire selon l'une des revendications précédentes.

11. Bâtiment selon la revendication précédente
**caractérisé en ce que**
le mur est un mur extérieur du bâtiment, de manière particulièrement préférée un mur extérieur statiquement porteur du bâtiment.
